# EUROPEAN PATENT SPECIFICATION

(11) **EP 4 281 405 B1**
(45) Date of publication and mention of the grant of the patent: **12.08.2026**
(21) Application number: 22742967.7
(22) Date of filing: 19.01.2022
(51) Int. Cl.: B82Y 20/00, C03B 37/01, C03C 3/07, C03C 3/11, C03C 4/12, C03C 10/00, C03C 10/16, C09K 11/02, C09K 11/66, C09K 11/77, C09K 11/88

(54) **QUANTUM DOT-DOPED GLASS NANOCOMPOSITE AS A RADIATION COLOUR CONVERTER AND PRODUCTION METHOD THEREOF**
QUANTENPUNKTDOTIERTER GLASNANOVERBUNDSTOFF ALS STRAHLUNGSFARBWANDLER UND HERSTELLUNGSVERFAHREN DAFÜR
NANOCOMPOSITE DE VERRE DOPÉ AVEC DES POINTS QUANTIQUES UTILISÉ COMME CONVERTISSEUR DE COULEUR DE RAYONNEMENT ET SON PROCÉDÉ DE PRODUCTION

(30) Priority: 20.01.2021 TR 202100883
(43) Date of publication of application: 29.11.2023
(73) Proprietor: Yildiz Teknik Üniversitesi, 34220 Istanbul (TR); Yildiz TTO A.S., 34220 Esenler/Istanbul (TR)
(72) Inventor: EROL, Erdinc, Esenler/Istanbul (TR); KIBRISLI, Orhan, Esenler/Istanbul (TR); ERSUNDU, Ali Ercin, Esenler/Istanbul (TR); CELIKBILEK ERSUNDU, Miray, Esenler/Istanbul (TR)
(74) Representative: Kaya, Erdem
(86) International application number: PCT/TR2022/050038
(87) International publication number: WO 2022/159061

(56) References cited:
- WO-A1-2018/078147
- WO-A1-2022/164412
- CN-A- 107 861 227
- CN-A- 112 080 276
- JP-A- H04 285 688
- US-A1- 2019 264 101
- US-A1- 2020 291 296
- US-A1- 2022 380 249
- XUE JUNPENG ET AL: "Fabrication, photoluminescence and applications of quantum dots embedded glass ceramics", CHEMICAL ENGENEERING JOURNAL, ELSEVIER, AMSTERDAM, NL, vol. 383, 9 October 2019 (2019-10-09), XP085971057, ISSN: 1385-8947, [retrieved on 20191009], DOI: 10.1016/J.CEJ.2019.123082
- KIBRISLI ORHAN ET AL: "Robust CsPbBr3 and CdSe / Dy3++CdSe quantum dot doped glass nanocomposite hybrid coupling as color converter for solid-state lighting applications", CHEMICAL ENGENEERING JOURNAL, ELSEVIER, AMSTERDAM, NL, vol. 420, 27 May 2021 (2021-05-27), XP086619931, ISSN: 1385-8947, [retrieved on 20210527], DOI: 10.1016/J.CEJ.2021.130542

## Description

### Technical Field of the Invention

The present invention relates to nanocomposites in the fields of materials science, optics, photonics and chemistry. In particular, the present invention relates to glass nanocomposites containing a radiation color converter, and production method thereof.

### Background Art

Existing commercial solid state white-radiating diodes (white LED or WLED) are formed by combining a blue-radiating LED chip and a Ce:YAG phosphor which absorbs some of the blue light and radiates yellow light, with silicone or organic binders, in which systems, white light is obtained by mixing blue and yellow light. Considering the visible region of the electromagnetic spectrum, the spectrum having only blue and yellow radiation is considered to be heterogeneous. Therefore, the capacity of WLEDs obtained by this method to display the colors in an environment to the observer is regarded insufficient in terms of NTSC (National Television System Committee) standard and CRI (Color Rendering Index) parameter. Meanwhile, scattering losses due to the refractive index difference between silicon or organic binder and phosphorus, low chemical and thermal stability of phosphorus material (Ce:YAG), degradation of the binder under UV light and/or the heat generated by the LED chip in time are problems concerning commercial WLEDs, and accordingly there is a need to improve WLEDs.

Quantum dots are nanosized (1-20 mm), semiconductive crystal materials that are hotspot for their unique properties such as high absorption cross-section, size-dependent band gap energy, adjustable radiation wavelength, and high photoluminescence quantum efficiency. With their superior properties, quantum dots have a high potential for use in radiation color converter applications such as solid state lighting, luminescent solar concentrator and display backlight. However, due to their strong ionic structure and high surface energy, quantum dots degrade when exposed to polar solvents such as water, to high temperature and high radiation intensity.

In order to improve the radiation color properties of the commercially used WLEDs, studies have been conducted to obtain a more homogeneous radiation spectrum by combining different materials that radiate separately red and green colors with blue LED chips. Most of these studies are based on the principle of depositing colloidal (wet chemistry, solution based) quantum dots on various substrate materials in the form of thin films. Also, various techniques have been developed, such as the production of quantum dots in organic or inorganic matrices such as polymers by means of surface modification and/or encapsulation. Although improvements are made with these methods in terms of radiation properties of quantum dots, the stability and degradation problems have not been solved at a desired level.

J. Xue et al, "Fabrication, photoluminescence and application of quantum dots embedded glass ceramics", Chem Eng. J., 383 (2020) 1233082 (D2) discloses nanoparticle embedded alass ceramics containing CdSe or CsPbBr3.

These colloidal based, quantum dot containing materials that is suitable to be prepared in the form of thin films are generally only stable at temperatures up to 200°C. Therefore, it can be said that their thermal resistance and stability are relatively low. Since colloidal based, quantum dot containing materials that is suitable to be prepared in the form of thin films are highly sensitive to moisture and oxygen, they start to degrade even in short time contacts in the order of minutes or hours; therefore, it can be said that the chemical stability thereof is relatively low. In addition, it can be said that the mechanical strength of colloidal based, quantum dot containing materials which can be prepared in thin film form is low. Quantum dots synthesized colloidally can also be embedded in various polymer matrices whose thermal and mechanical strength is considerably lower than inorganic glasses.

In order to combine the blue light originating from an LED chip with other primary colors (red, green) or the mixtures thereof, different glass layers doped with different quantum dots are disposed on the LED chip so as to obtain the white light. However, using more than one glass layer on the LED chip in these designs causes the light to be refracted as it passes through the layers, resulting in scattering losses. Therefore, obtaining a homogeneous radiation spectrum by using a single glass layer is important in terms of increasing radiation intensity.

In order to achieve superior radiation properties, the red, green and blue radiation bands of the white light components must cover a large part of the visible region. In the studies to obtain white light using lanthanide ions, the full width at half maximum (in short: FWHM) of rare earth ions is narrow, and the fixed central wavelength values prevent a large part of the visible region of the electromagnetic spectrum to be covered. At this point, the radiation bands of quantum dots with broad and adjustable wavelengths make it possible to obtain radiation bands that cover the entire visible region.

In devices developed to produce white light using a blue LED chip and perovskite quantum dots (CsPbBr₃, green radiation), the red radiation is obtained by using CsPbI₃ PQDs (see Figure 1) with low quantum efficiency, lanthanide ions (see Figure 2) with narrow FWHM and fixed central wavelength values such as Eu³⁺, or phosphorus materials with low chemical and thermal resistance such as Eu²⁺:CaAlSiN₃ (see Figure 3). The white light produced using these materials cannot meet the properties expected from an ideal white light source.

### Objects of the Invention

The main object of the invention is to eliminate the problems encountered in the prior art.

Another object of the invention is to prevent the degradation of quantum dots and to ensure that the radiation properties can be preserved for a long period time.

Another object of the invention is to provide a nanocomposite structure in which improved radiation properties and a high quantum dot strength are provided in a radiation color converter.

Still another object of the invention is to provide a method for obtaining such a nanocomposite structure.

### Summary of the Invention

The present invention provides a glass nanocomposite doped with one or more CsPbBr₃ quantum dots and one or more CdSe quantum dots, and a method for obtaining same.

The nanocomposite of the invention is suitable for use as a radiation color converter in a solid state lighting system or a display panel backlight system, or as a luminescent solar concentrator in a solar cell.

Therefore, the present invention also provides a solid state lighting system, or a display panel backlight system, comprising the inventive glass nanocomposite as a radiation color converter, and a solar cell comprising the inventive glass nanocomposite as a luminescent solar concentrator.

### Brief Description of the Drawings

The present invention is exemplified below with reference to the accompanying figures for better understanding thereof, which examples are only illustrative of the embodiments of the present invention and are not limiting other embodiments and general functions providing the solution of the technical problem.

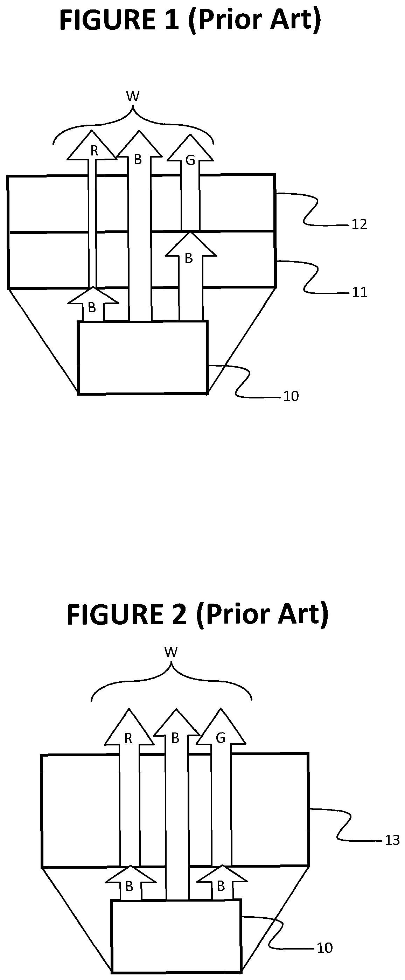

Figure 1 is a schematic view of a next generation comparative WLED design that is suitable to be used for the generation of white light.
Figure 2 is a schematic view of another next generation comparative WLED design that is suitable to be used for the generation of white light.

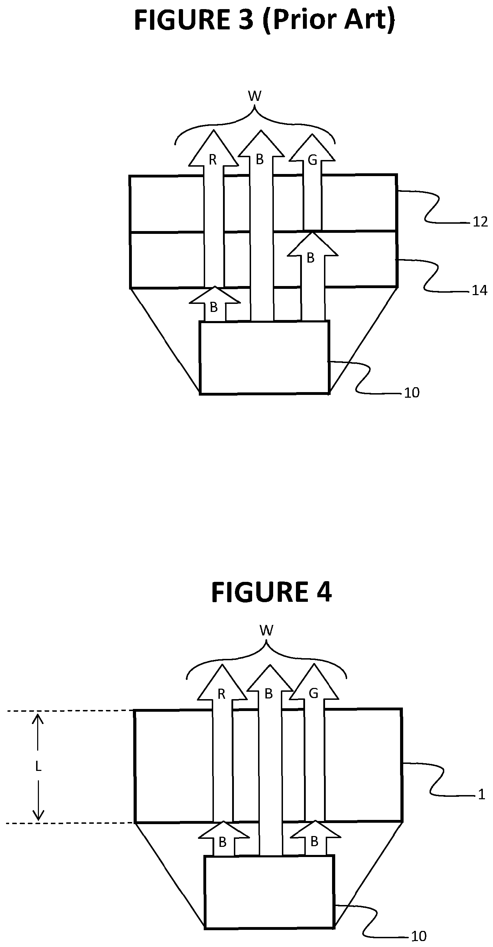

Figure 3 is a schematic view of another next generation comparative WLED design that is suitable to be used for the generation of white light.
Figure 4 is a schematic view of a WLED design presented within the scope of the present invention, for use in the generation of white light.

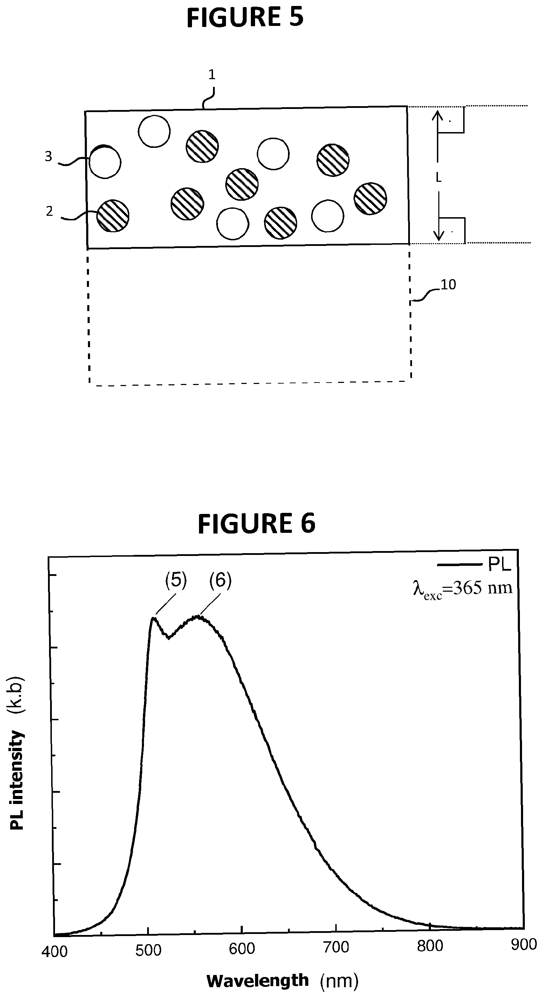

Figure 5 is a schematic cross-sectional view of the inventive quantum dot doped glass nanocomposite included in a solid state lighting system, for example together with an LED chip.
Figure 6 is a photoluminescence (PL) graph of the quantum dot doped glass nanocomposite presented within the scope of the present invention. Here, the stimulative wavelength is 365nm.

### Detailed Description of the Invention

Hereinafter, the present invention is described in detail, based on the drawings, whose brief description given above. The list of reference symbols used in the figures is as follows;
- 1: glass nanocomposite of the invention
- 2: CdSe quantum dots
- 3: CsPbBr₃ quantum dots
- 5: characteristic photoluminescence peak of the CsPbBr₃ quantum dot
- 6: characteristic photoluminescence peak of the CdSe quantum dot
- 10: light source, such as LED chip, such as blue LED chip or UV LED chip
- 11: first glass nanocomposite layer doped with a PQD such as CsPbI₃ that has low red radiation quantum efficiency
- 12: second glass nanocomposite layer doped with green-radiating (CsPbBr₃) PQD
- 13: glass nanocomposite layer doped with a lanthanide such as red-radiating Eu³⁺ with narrow FWHM and fixed central wavelength values, and with CsPbBr₃ PQD
- 14: first layer consisting of red-radiating Eu²⁺:CaAlSiN₃-based phosphorus or red-radiating Eu²⁺:CaAlSiN₃-based phosphorus
- B: blue light
- G: green radiation
- R: red radiation
- W: white light
- L: thickness

With the present invention, a nanocomposite is developed in order to eliminate the disadvantages mentioned in the background art section.

In order to prevent the degradation of quantum dots and to preserve their exceptional radiation properties for a long period of time, it is appropriate to encapsulate them in a thermally, chemically and mechanically stable material. In this context, glass stands out as the encapsulation material with the highest potential for their high optical transmittance, ease of production, 100% recyclability and exceptional thermal, chemical and mechanical resistance. Since the synthesis of quantum dots directly in glass matrices results in their zero contact with the outside environment and passivation of their surfaces, their radiation properties can be preserved for a long period time.

Glass nanocomposites that are to be obtained from the synthesis of quantum dots in suitable glass matrices will meet such shortcomings of solar cells, which degrade under UV light and cannot produce energy with UV light, especially WLED solid state lighting systems, and the expectation of obtaining a wide color gamut in display panels, with their thermal and chemical stabilities and the radiation color converter properties, and will allow the development of new commercial products that can use radiation color converters.

### Comparative example 1:

Figure 1 shows a device comprising a light source (10) (e.g., a blue LED chip) emitting blue light (B) and developed to produce white light by the effect of doped nanocomposite.

The device includes a first glass nanocomposite layer (11) doped with perovskite quantum dots (in short: PQD) such as CsPbI₃, which have low red radiation (R) quantum efficiency, as a radiation color converter, and also a second glass nanocomposite layer (12) doped with green radiating (G) (CsPbBr₃) PQD. Thus, as the blue rays (B) originating from blue radiation pass through the nanocomposite layers, PQDs in nanocomposite layers generate red radiation (R) and green radiation (G) so that white light (W) (or white color) is obtained.

The low efficiency of red radiation (R) due to CsPbI₃ doping is represented with a thin arrow.

### Comparative example 2:

Figure 2 shows a device comprising a blue LED chip (10) emitting blue light (B) and developed to produce white light by the effect of a doped nanocomposite.

The device includes a glass nanocomposite layer (13) doped with a red (R) radiating lanthanide such as Eu³⁺, as a radiation color converter, and green (G) radiating (CsPbBr₃) PQD. Thus, as the blue rays or blue light (B) pass through the nanocomposite, Eu³⁺ ions in nanocomposite generate a red radiation (R) and PQDs generate a green radiation (G) so that white light (W) (or white color) is obtained.

Here, the absorption cross-sectional area, quantum efficiency and FWHM values of Eu³⁺ ions used for red radiation are low.

### Comparative example 3:

Figure 3 shows a device comprising a blue LED chip emitting blue light (B), which is also developed to produce white light (W) by the effect of a first layer and a second being doped nanocomposite.

The device includes a first layer (14) consisting of red radiating Eu²⁺:CaAlSiN₃-based phosphorus or red radiating Eu²⁺:CaAlSiN₃-based phosphorus, as a radiation color converter, and also a second glass nanocomposite layer (12) doped with green radiating (G) (CsPbBr₃) PQD. Thus, as the blue rays (B) pass through the first layer (14) and the second layer (12), said first and second layers separately emit red radiation (R) and green radiation (G) so that white light (W) (or white color) is obtained.

The red radiating phosphor material used herein has low chemical and thermal resistance.

### Example 4, the effect of the nanocomposite of the invention:

Figure 4 shows a device comprising a light source (10) (e.g., a blue LED chip) emitting blue ray (B) and developed to produce white light by the effect of doped nanocomposite according to the present invention.

The device includes a glass nanocomposite layer (i.e., the inventive glass nanocomposite (1) doped with quantum dots of CdSe and CsPbBr₃) doped with green (G) radiating CsPbBr₃ (cesium lead bromide) perovskite quantum dots (in short: PQD), and red (R) radiating CdSe (cadmium selenide) QD, as a radiation color converter. Thus, as the blue rays (B) originating from the blue radiation pass through the nanocomposite layer (1), CdSe quantum dots (2) in the nanocomposite layer emit red radiation (R) and CsPbBr₃ (perovskite) quantum dots (3) emit green radiation (G) so that white light (W) (or white color) is obtained.

With the CdSe doping, the red radiation (R) efficiency is high.

In light of the above, a glass nanocomposite (1) doped with CdSe quantum dots (2) and CsPbBr₃ quantum dots (3) is presented in the present invention. With the CdSe quantum dots (2), red and preferably additional yellow radiation is achieved. With the CsPbBr₃ quantum dots (3), green radiation is achieved. With the improvement of the present invention, silicate glass nanocomposite (1), doped with green radiating CsPbBr₃ quantum dots (3) as well as red and yellow radiating CdSe quantum dots (2) with high FWHM, have high thermal, chemical and mechanical strength. In this context, a radiation color converter having ideal properties is proposed by synthesizing CdSe quantum dots (2) and CsPbBr₃ quantum dots (3), which radiate in red and green regions with high efficiency, in a single glass matrix.

The inventive glass nanocomposite (1) radiates red light (R) and green light (G) with blue light emitted from a light source (10) (e.g., an LED chip) coupled with it, and radiation of all colors are combined to provide the radiation color properties expected from an ideal white light source.

The quantum dot glass nanocomposite (1) which is the subject of the present invention has at least the following advantages compared to colloidal-based materials containing quantum dots, which can be prepared in thin film form:
- After repeated heating-cooling cycles up to 400°C, it preserves its initial original radiation properties, therefore said nanocomposite provides a high thermal stability.
- Even when it is immersed in water for more than 60 days no adverse effects on the radiation properties were observed, thus said nanocomposite has a high chemical stability.
- Quantum dot-doped glass nanocomposites have very high mechanical strength compared to colloidal-based thin films and quantum dot-doped polymers.
- CdSe quantum dots (2) and CsPbBr₃ quantum dots (3) are sensitive to different stimulation wavelengths. Therefore, said nanocomposite allows to adjust the radiation color to green, red, yellow and orange depending on the stimulation wavelength, which can be in the range of 345 nm - 405 nm.

The glass nanocomposite (1) which is the subject of the invention containing CdSe quantum dots (2) and CsPbBr₃ quantum dots (3) simultaneously is schematically shown in Figure 5. In Figure 5, dashed lines are used to symbolize that the glass nanocomposite (1) of the invention can be coupled with, for example, a light source (10).

In addition to its superior and adjustable radiation properties, the glass nanocomposite (1) of the invention, due to its thermal, chemical and mechanical resistance, has the potential for use as a radiation color converter in durable solid state lighting devices, as illustrated in Fig. 4 and Fig. 5, or solar cells (not shown), or display panel backlight system (not shown) technologies.

The present invention also provides a method for obtaining the glass nanocomposite (1) of the invention.

The method includes the following steps:
a) preparing a blend of glass,
b) melting the glass blend prepared in step a,
c) obtaining a molded sample by pouring the glass blend melted in step b into a mold,
d) annealing of the molded sample obtained in step c, thus obtaining an annealed sample,
e) controlled crystallization of CdSe and CsPbBr₃ quantum dots by heat treatment of the annealed sample obtained in step d at a temperature above the glass transition temperature, thereby obtaining a glass nanocomposite containing quantum dots,
f) controlled cooling of the glass nanocomposite obtained in step e.

The glass blend in step a of the method is prepared to contain the following components, with the total mole percent concentrations of each constituent component being 100:
SiO₂ in the range of 40% to 60% by mole; alkali metal oxide in the range of 15% to 25% by mole; AL₂O₃ in the range of 2% to 10% by mole; ZnO in the range of 5% to 15% by mole, CsBr in the range of 3% to 7% by mole, PbBr₂ in the range of 6% to 14% by mole, as well as
- CdO in the range of 0.5% to 5% by mole and ZnSe in the range of 0.5% to 5% by mole, or
- Cdse in the range of 0.5% to 5% by mole.

Said alkali metal oxide may be one or more selected from Li₂O, Na₂O, and K₂O.

As can be understood, the glass blend may contain CdO and ZnSe together, and as a result of the chemical reaction that will take place between them during the performance of the method, CdSe (thus CdSe quantum dots (2)) is formed as a product. Alternatively, CdSe can be directly included in the glass blend and does not experience chemical transformation while the method is performed.

Therefore, the mole percent composition of the glass blend can be formed by considering the components shown in either Table 1 and Table 2 below, and the mole percent concentrations corresponding to said components. Here, the term mole percent concentration is the proportion of each component in the total number of moles of components in the glass blend.

**Table 1: The first alternative for the components in the glass blend in step a of the method and their percent concentration based on the total number of moles in the glass blend.**

| Component | Concentration of the component in the glass blend (% mole) |
|---|---|
| SiO₂ | in the range of 40% to 60% |
| alkali metal oxide | in the range of 15% to 25% |
| Al₂O₃ | in the range of 2% to 10% |
| ZnO | in the range of 5% to 15% |
| CsBr | in the range of 3% to 7% |
| PbBr₂ | in the range of 6% to 14% |
| CdO | in the range of 0.5% to 5% |
| ZnSe | in the range of 0.5% to 5% |

**Table 2: The second alternative for the components in the glass blend in step a of the method and their percent concentration based on the total number of moles in the glass blend.**

| Component | Concentration of the component in the glass blend (% mole) |
|---|---|
| SiO₂ | in the range of 40% to 60% |
| alkali metal oxide | in the range of 15% to 25% |
| Al₂O₃ | in the range of 2% to 10% |
| ZnO | in the range of 5% to 15% |
| CsBr | in the range of 3% to 7% |
| PbBr₂ | in the range of 6% to 14% |
| CdSe | in the range of 0.5% and 5% |

In the melting process in step b of the method, the glass blend can be raised to a temperature value preferably in the range of 1000°C to 1450°C. Said temperature may be referred to as the melting temperature. The glass blend can be placed in a pot for the melting process, said pot may be made from a material resistant to temperatures above 1000°C, such as quartz, alumina or platinum.

Preferably, in step c of the method, the mold may be preheated to a temperature in the range of 350°C to 550°C prior to the casting process. The temperature preferred for preheating may be referred to as the preheating temperature. The mold may be formed from a metallic material such as stainless steel, brass or copper.

The annealing in step d of the method is preferably carried out for a period of 1 to 5 hours. Said period in which the annealing process is carried out may be referred to as an annealing period. The glass transition temperature of the glass blend prepared according to the description in step a of the method is expected to be 20°C to 100°C higher than a temperature in the range 350°C to 550°C. In this context, the annealing process may preferably be performed at a temperature value below 20°C to 100°C of the glass transition temperature of the molded sample, i.e., for example in the range of 350°C to 550°C. The temperature in the annealing process may be referred to as an annealing temperature. The purpose of the annealing process is to eliminate internal stress resulting from rapid cooling.

The heat treatment in step e of the method may, for example, have a single stage or for example two stages or more. The heat treatment in step e of the method may preferably be carried out for a period in the range of 1 to 72 hours. Said period in which the heat treatment is carried out may be referred to as a heat treatment period. The heat treatment in step e of the method may preferably be carried out at a temperature in the range of 400°C to 600°C; therefore, in this case, the temperature of the heat treatment corresponds to a temperature value above the glass transition temperature. The temperature value during heat treatment may be referred to as a heat treatment temperature.

The controlled cooling in step f of the method may preferably be continued to a temperature corresponding to a temperature below 30°C, more preferably to a temperature corresponding to room temperature (20°C). The temperature reached at the end of the said controlled cooling may be referred to as an operating temperature. Preferably, step f of the method may be followed by step g below:
g) preparing at least one surface of the sample cooled in step f at optical quality.

Here, the process of preparing the surface at optical quality may include any of the methods applied and known in the field of optics. The process of preparing at optical quality may be carried out by means of grinding and polishing, and may, for example, correspond to the reduction of the average roughness of the surface to 1 micrometer or less.

Preferably, prior to step g of the method, a thickness (L) of the sample cooled in step f is brought to a value in the range of 0.1 to 2 mm. Bringing the thickness (L) of the sample to a value in the range of 0.1 to 2 mm may be achieved, for example, by known sample preparation techniques. Sample preparation techniques include, for example, any of the methods of grinding, cutting, mechanical or chemical etching. Here, the term thickness (L) can be considered to correspond to a length of a light transmittance path between a first surface and a second surface of the glass nanocomposite of the invention. Preferably said term of thickness (L) may be considered to correspond to a length of a light transmittance path perpendicular to at least one of these surfaces, i.e., in the perpendicular direction (see Figure 4). More preferably, said term of thickness (L) may be considered to correspond to a length of a light transmittance path that is perpendicular to both of these surfaces, i.e., in the perpendicular direction (see Figure 5). Such thickness (L) value may be considered as a minimum value at which the light transmittance path is the shortest.

With the method of the invention, a glass nanocomposite (1) is obtained which comprises CdSe quantum dots (2) and CsPbBr₃ quantum dots (3) dispersed homogenously in the glass matrix, with a quantum efficiency above 10%. The diameters of the resulting quantum dots (2 and 3) can be in the range of 1.5 nm to 10 nm.

The present invention also proposes the use of the inventive glass nanocomposite (1) doped with CdSe quantum dot (2) and CsPbBr₃ quantum dot (3) in solid state lighting applications. A solid state lighting application suitable for this specification may for example be a WLED or a white LED. In the context of said use, the glass nanocomposite (1) of the invention is disposed on a light source (10) (e.g., a UV light source, blue light source or violet light source), in order to allow CdSe quantum dots (2) and CsPbBr₃ quantum dots (3) to radiate red (R) (red-yellow) and green radiation (G), respectively. White color (W) (or white light) is obtained as a mixture of all the resulting radiations (R+G+B). Therefore, the present invention also provides a solid state lighting system containing the inventive glass nanocomposite (1) as a radiation color converter.

The present invention also proposes the use of the inventive glass nanocomposite (1) in a display panel backlight. A wide color gamut (Rec. 2020) is needed for display panel backlights. A wide color gamut that is suitable to be used in display panel backlights can be obtained by simply adjusting the ratios of CsPbBr₃ and CdSe in the glass nanocomposite of the invention and the current, voltage and radiation wavelength values of the light source (10). Accordingly, the present invention also provides a display panel backlight system (not shown) comprising the glass nanocomposite (1) of the invention as a radiation color converter.

The present invention also proposes the use of the inventive glass nanocomposite (1) as a luminescent solar concentrator (in short: LSC) in solar cells. Commercially used Si solar cells are degraded by the effect of UV light and cannot produce energy by absorbing UV light. CdSe quantum dots (2) and CsPbBr₃ quantum dots (3) can absorb UV light and radiate in the visible region, i.e., in the region where commercially used solar cells are sensitive. When the glass nanocomposites of the invention are combined with solar cells by selecting the appropriate geometry, they can increase the performance of the solar cells and extend their lifetime. Therefore, the present invention also provides a solar cell (not shown) comprising the glass nanocomposite (1) of the invention as a luminescent solar concentrator.

## Claims

1. A glass nanocomposite (1), which is doped with one or more CdSe quantum dots (2) and one or more CsPbBr₃ quantum dots (3).

2. The nanocomposite (1) according to claim 1, wherein said one or more CdSe quantum dots (2) and one or more CsPbBr₃ quantum dots (3) have a radius in the range of 1.5 nm to 10 nm.

3. A solid state lighting system, comprising the glass nanocomposite (1) according to any one of claim 1 or 2.

4. A display panel backlight system, comprising the glass nanocomposite (1) according to any one of claim 1 or 2.

5. A solar cell, comprising the glass nanocomposite (1) according to any one of claim 1 or 2 as a luminescent solar concentrator.

6. A method for obtaining a glass nanocomposite (1) doped with one or more CdSe quantum dots (2) and one or more CsPbBr3 quantum dots (3), said method comprises the following steps:
a) preparing a blend of glass to contain the following components, with the total of the mole percent concentrations of each component being 100:
SiO₂ in the range of 40% to 60% by mole; one or more alkali metal oxides selected from Li₂O, Na₂O and K₂O with a total range of 15% to 25% by mole; Al₂O₃ in the range of 2% to 10% by mole; ZnO in the range of 5% to 15% by mole, CsBr in the range of 3% to 7% by mole, PbBr₂ in the range of 6% to 14% by mole; and
- CdO in the range of 0.5% to 5% by mole and ZnSe in the range of 0.5% to 5% by mole, or
- CdSe in the range of 0.5% to 5% by mole;
b) melting the glass blend prepared in step a,
c) obtaining a molded sample by pouring the glass blend melted in step b into a mold,
d) annealing of the molded sample obtained in step c, thus obtaining an annealed sample,
e) controlled crystallization of CdSe quantum dots and CsPbBn quantum dots by heat treatment of the annealed sample obtained in step d at a temperature above the glass transition temperature, thereby obtaining a glass nanocomposite sample containing quantum dots,
f) controlled cooling of the glass nanocomposite obtained in step e.

7. The method according to claim 6, wherein in the melting process in step b, the glass blend is raised to a temperature value in the range of 1000°C to 1450°C.

8. The method according to any one of claim 6 or 7, wherein in step c, prior to the casting process, the mold is preheated to a temperature in the range of 350°C to 550°C.

9. The method according to any one of claims 6 to 8, wherein in step d the annealing process is carried out for a period of 1 to 5 hours.

10. The method according to any one of claims 6 to 9, wherein during the annealing process in step d, the temperature value is in the range of 350°C to 550°C.

11. The method according to any one of claims 6 to 10, wherein the heat treatment in step e is carried out for a period of 1 to 72 hours.

12. The method according to any one of claims 6 to 11, wherein the heat treatment in step e is carried out at a temperature in the range of 400°C to 600°C.

13. The method according to any one of claims 6 to 12, wherein the controlled cooling in step f is continued until the temperature of 20°C is reached.

14. The method according to any one of claims 6 to 13, comprising the following step after step f:
g) preparing at least one surface of the sample cooled in step f such that the average roughness thereof is 1 micrometer or less.

15. The method according to claim 14, comprising, before step g, bringing a thickness of the sample cooled in step f to a value in the range of 0.1 mm to 2 mm.

## Patentansprüche

1. Glas-Nanoverbundstoff (1), der mit einem oder mehreren CdSe-Quantenpunkten (2) und einem oder mehreren CsPbBr₃-Quantenpunkten (3) dotiert ist.

2. Nanoverbundstoff (1) nach Anspruch 1, wobei der eine oder die mehreren CdSe-Quantenpunkte (2) und der eine oder die mehreren CsPbBr₃-Quantenpunkte (3) einen Radius im Bereich von 1,5 nm bis 10 nm aufweisen.

3. Festkörperbeleuchtungssystem, umfassend den Glas-Nanoverbundstoff (1) gemäß einem der Ansprüche 1 oder 2.

4. Hintergrundbeleuchtungssystem für ein Anzeigepanel, umfassend den Glas-Nanoverbundstoff (1) nach einem der Ansprüche 1 oder 2.

5. Solarzelle, umfassend den Glas-Nanoverbundstoff (1) gemäß einem der Ansprüche 1 oder 2 als lumineszierenden Solarkonzentrator.

6. Verfahren zur Erhaltung eines Glas-Nanoverbundstoffs (1), das mit einem oder mehreren CdSe-Quantenpunkten (2) und einem oder mehreren CsPbBr₃-Quantenpunkten (3) dotiert ist, wobei das Verfahren die folgenden Schritte umfasst:
a) Bereitstellen einer Glasmischung, die die folgenden Komponenten enthält, wobei die Summe der Molprozentkonzentrationen jeder Komponente 100 beträgt:
SiO₂ im Bereich von 40 % bis 60 Mol-%; ein oder mehrere Alkalimetalloxide, ausgewählt aus Li₂O, Na₂O und K₂O, mit einem Gesamtbereich von 15 % bis 25 Mol-%; Al₂O₃ im Bereich von 2 % bis 10 Mol-%; ZnO im Bereich von 5 % bis 15 Mol-%, CsBr im Bereich von 3 % bis 7 Mol-%, PbBr₂ im Bereich von 6 % bis 14 Mol-%; und
- CdO im Bereich von 0,5 % bis 5 Mol-% und ZnSe im Bereich von 0,5 % bis 5 Mol-%, oder
- CdSe im Bereich von 0,5 % bis 5 Mol-%;
b) Schmelzen der in Schritt a bereitgestellten Glasmischung,
c) Erhalten einer geformten Probe durch Eingießen der in Schritt b geschmolzenen Glasmischung in eine Form,
d) Tempern der in Schritt c erhaltenen geformten Probe, wodurch eine getemperte Probe erhalten wird,
e) kontrollierte Kristallisation von CdSe-Quantenpunkten und CsPbBn-Quantenpunkten durch Wärmebehandlung der in Schritt d erhaltenen getemperten Probe bei einer Temperatur oberhalb der Glasübergangstemperatur, wodurch eine Quantenpunkte enthaltende Glas-Nanoverbundstoff-Probe erhalten wird,
f) kontrolliertes Abkühlen des in Schritt e erhaltenen Glas-Nanoverbundstoffs.

7. Verfahren nach Anspruch 6, wobei bei dem Schmelzvorgang in Schritt b die Glasmischung auf einen Temperaturwert im Bereich von 1000 °C bis 1450 °C erhitzt wird.

8. Verfahren nach einem der Ansprüche 6 oder 7, wobei in Schritt c vor dem Gießvorgang die Form auf eine Temperatur im Bereich von 350 °C bis 550 °C vorgeheizt wird.

9. Verfahren nach einem der Ansprüche 6 bis 8, wobei in Schritt d der Tempervorgang über einen Zeitraum von 1 bis 5 Stunden durchgeführt wird.

10. Verfahren nach einem der Ansprüche 6 bis 9, wobei während des Tempervorgangs in Schritt d der Temperaturwert im Bereich von 350 °C bis 550 °C liegt.

11. Verfahren nach einem der Ansprüche 6 bis 10, wobei die Wärmebehandlung in Schritt e über einen Zeitraum von 1 bis 72 Stunden durchgeführt wird.

12. Verfahren nach einem der Ansprüche 6 bis 11, wobei die Wärmebehandlung in Schritt e bei einer Temperatur im Bereich von 400 °C bis 600 °C durchgeführt wird.

13. Verfahren nach einem der Ansprüche 6 bis 12, wobei die kontrollierte Abkühlung in Schritt f fortgesetzt wird, bis eine Temperatur von 20 °C erreicht ist.

14. Verfahren nach einem der Ansprüche 6 bis 13, umfassend den folgenden Schritt nach Schritt f:
g) Aufbereiten mindestens einer Oberfläche der in Schritt f gekühlten Probe, sodass deren durchschnittliche Rauheit 1 Mikrometer oder weniger beträgt.

15. Verfahren nach Anspruch 14, umfassend vor Schritt g das Einstellen einer Dicke der in Schritt f abgekühlten Probe auf einen Wert im Bereich von 0,1 mm bis 2 mm.

## Revendications

1. Un nanocomposite de verre (1) dopé avec un ou plusieurs points quantiques de CdSe (2) et un ou plusieurs points quantiques de CsPbBr₃ (3).

2. Le nanocomposite (1) selon la revendication 1, dans lequel ledit ou lesdits points quantiques CdSe (2) et ledit ou lesdits points quantiques CsPbBr₃ (3) ont un rayon compris entre 1,5 nm et 10 nm.

3. Un système d'éclairage à l'état solide, comprenant le nanocomposite de verre (1) selon l'une quelconque des revendications 1 ou 2.

4. Un système de rétroéclairage pour écran, comprenant le nanocomposite de verre (1) selon l'une quelconque des revendications 1 ou 2.

5. Une cellule solaire comprenant le nanocomposite de verre (1) selon l'une quelconque des revendications 1 ou 2 en tant que concentrateur solaire luminescent.

6. Une méthode permettant d'obtenir un nanocomposite de verre (1) dopé avec un ou plusieurs points quantiques de CdSe (2) et un ou plusieurs points quantiques de CsPbBr₃ (3), ladite méthode comprenant les étapes suivantes :
a) préparer un mélange de verre contenant les composants suivants, la somme des concentrations en pourcentage molaire de chaque composant étant égale à 100 :
SiO₂ dans une plage comprise entre 40 % et 60 % en moles ; un ou plusieurs oxydes de métaux alcalins choisis parmi Li₂O, Na₂O et K₂O, dans une plage totale comprise entre 15 % et 25 % en moles ; de l'Al₂O₃ dans une plage comprise entre 2 % et 10 % en moles ; du ZnO dans une plage comprise entre 5 % et 15 % en moles, du CsBr dans une plage comprise entre 3 % et 7 % en moles, du PbBr₂ dans une plage comprise entre 6 % et 14 % en moles ; et
- du CdO dans une plage comprise entre 0,5 % et 5 % en moles et du ZnSe dans une plage comprise entre 0,5 % et 5 % en moles, ou
- du CdSe dans une plage comprise entre 0,5 % et 5 % en moles ;
b) faire fondre le mélange de verre préparé à l'étape a,
c) obtenir un échantillon moulé en coulant le mélange de verre fondu à l'étape b dans un moule,
d) recuire l'échantillon moulé obtenu à l'étape c, ce qui permet d'obtenir un échantillon recuit,
e) cristallisation contrôlée de points quantiques de CdSe et de points quantiques de CsPbBn par traitement thermique de l'échantillon recuit obtenu à l'étape d à une température supérieure à la température de transition vitreuse, ce qui permet d'obtenir un échantillon de nanocomposite de verre contenant des points quantiques,
f) refroidissement contrôlé du nanocomposite de verre obtenu à l'étape e.

7. La méthode selon la revendication 6, dans laquelle, lors du processus de fusion de l'étape b, le mélange de verre est porté à une température comprise entre 1000 °C et 1450 °C.

8. La méthode selon l'une quelconque des revendications 6 ou 7, dans laquelle, à l'étape c, avant le procédé de coulée, le moule est préchauffé à une température comprise entre 350 °C et 550 °C.

9. La méthode selon l'une quelconque des revendications 6 à 8, dans laquelle, à l'étape d, le procédé de recuit est effectué pendant une durée de 1 à 5 heures.

10. La méthode selon l'une quelconque des revendications 6 à 9, dans laquelle, au cours du procédé de recuit de l'étape d, la température est comprise entre 350 °C et 550 °C.

11. La méthode selon l'une quelconque des revendications 6 à 10, dans laquelle le traitement thermique de l'étape e est effectué pendant une durée comprise entre 1 et 72 heures.

12. La méthode selon l'une quelconque des revendications 6 à 11, dans laquelle le traitement thermique de l'étape e est effectué à une température comprise entre 400 °C et 600 °C.

13. La méthode selon l'une quelconque des revendications 6 à 12, dans laquelle le refroidissement contrôlé de l'étape f est poursuivi jusqu'à ce que la température atteigne 20 °C.

14. La méthode selon l'une quelconque des revendications 6 à 13, comprenant l'étape suivante après l'étape f :
g) préparer au moins une surface de l'échantillon refroidi à l'étape f de manière à ce que sa rugosité moyenne soit inférieure ou égale à 1 micromètre.

15. La méthode selon la revendication 14, comprenant, avant l'étape g, l'amener l'épaisseur de l'échantillon refroidi à l'étape f à une valeur comprise entre 0,1 mm et 2 mm.
